# EUROPEAN PATENT APPLICATION

(11) **EP 4 776 285 A1**
(43) Date of publication of application: **15.07.2026**
(21) Application number: 25217591.4
(22) Date of filing: 21.11.2025
(51) Int. Cl.: G11C 7/10, G11C 7/14

(54) **MEMORY DEVICE GENERATING PER-PIN REFERENCE VOLTAGE**

(30) Priority: 13.01.2025 KR 20250004660
(71) Applicant: SK hynix Inc., Bubal-eub Icheon-si Gyeonggi-do 17336 (KR)
(72) Inventor: SEO, Beom Kyu, 17336 Icheon-si, Gyeonggi-do (KR); OK, Sung Hwa, 17336 Icheon-si, Gyeonggi-do (KR); JANG, Jun Seo, 17336 Icheon-si, Gyeonggi-do (KR); CHOI, Eun Ji, 17336 Icheon-si, Gyeonggi-do (KR); HONG, Jae Hyeong, 17336 Icheon-si, Gyeonggi-do (KR)
(74) Representative: Isarpatent

(57) **Abstract**

A memory device comprises a plurality of reference voltage generators, each of which corresponds to a plurality of data pins and generates a reference voltage for each of the corresponding data pins, with each of the plurality of reference voltage generators comprising a voltage divider that divides a power supply voltage into a plurality of divided voltages; a control logic that receives a first code indicating internal reference voltage level information and a second code indicating offset voltage information for a corresponding data pin, and that generates a control code based on the first and second codes; and a reference voltage selector comprising tree-structured transfer gates that select one of the plurality of divided voltages in response to the control code and output the selected one as a reference voltage.

## Description

### BACKGROUND

### 1. Technical Field

Embodiments of the present disclosure relate to a memory device that generates a PER-PIN reference voltage.

### 2. Related Art

A memory device can receive a data signal through multiple channels. The memory device has multiple receiving buffers and can determine the logic level of the received data signal using the receiving buffer. The receiving buffer can determine, based on the reference voltage, whether the logic level of the received data signal is "1" or "0".

If the reference voltage is inaccurate, the error rate for determining the logic level of the data signal increases and the performance of the entire system deteriorates. In general, as the data rate increases, the setup time and hold time for latching the data signal by comparing it with the reference voltage become shorter, so a more precise reference voltage is required. Accordingly, a method of setting the reference voltage differently for each pin by considering the characteristics of the data signal and the characteristics of the channel through which the data signal is transmitted has been proposed.

### SUMMARY

Embodiments of the present disclosure may provide a memory device that generates a PER-PIN reference voltage.

The objects of the embodiments of the present disclosure are not limited to those mentioned in this specification, and other objects that are not mentioned can be clearly understood by those skilled in the art from the description below.

Embodiments of the present disclosure may provide a memory device comprising a plurality of reference voltage generators, each corresponding to a plurality of data pins and generating a reference voltage for each of the corresponding data pins, wherein each of the plurality of reference voltage generators comprises: a voltage divider that divides a power supply voltage into a plurality of divided voltages; a control logic that receives a first code indicating an internal reference voltage level information and a second code indicating an offset voltage information for a corresponding data pin, and generates a control code based on the first and second codes; and a reference voltage selector comprising a plurality of tree-structured transfer gates that selects one of the plurality of divided voltages in response to the control code and output the selected divided voltage as the reference voltage.

Embodiments of the present disclosure may provide a memory device comprising a plurality of input/output circuit regions, each of which corresponds to a plurality of data pins, wherein each of the plurality of input/output circuit regions includes a receiving buffer region and a reference voltage generator region that provides a reference voltage to the receiving buffer region, and wherein the reference voltage generator region comprises: a voltage divider region that divides a power supply voltage into a plurality of divided voltages; a control logic region that receives a first code indicating internal reference voltage level information and a second code indicating offset voltage information for a corresponding data pin and generates a control code based on the first and second codes; and a reference voltage selector region that selects one of the plurality of divided voltages in response to the control code and outputs the selected divided voltage as the reference voltage.

According to embodiments of the present disclosure, a memory device generating a PER-PIN reference voltage, which is capable of shortening the settling time of the reference voltage, may be provided.

According to embodiments of the present disclosure, a memory device that generates a PER-PIN reference voltage, which is capable of improving area efficiency, may be provided.

The advantages of embodiments of the present disclosure are not limited to the advantages mentioned above. Other advantages not mentioned can be clearly understood by those skilled in the art from the description of the claims.

### BRIEF DESCRIPTION OF THE DRAWINGS

The present disclosure will be more fully understood from the detailed description and accompanying drawings provided below, which are provided solely for explanation purposes and do not limit the scope of the present disclosure.
FIG. 1 is a block diagram illustrating a system including a memory device according to embodiments of the present disclosure.
FIG. 2 is a block diagram illustrating a data driver according to embodiments of the present disclosure.
FIG. 3 is a block diagram illustrating a first reference voltage generator of FIG. 2.
FIG. 4 is an exemplary circuit diagram of a voltage divider of FIG. 3.
FIG. 5 is an exemplary circuit diagram of a control logic of FIG. 3.
FIG. 6 is a configuration diagram of a reference voltage selector of FIG. 3.
FIG. 7 is a graph illustrating a change in a reference voltage level of a DQ0 pin according to a change in an offset enable signal, first code, and second code in a memory device according to an embodiment of the present disclosure.
FIG. 8 is a schematic diagram illustrating an arrangement of receiving buffers and reference voltage generators according to embodiments of the present disclosure.
FIG. 9 to FIG. 11 are schematic diagrams illustrating a layout structure of first input/output circuit area of FIG. 8.

### DETAILED DESCRIPTION

Hereinafter, embodiments of the disclosure are described in detail with reference to the accompanying drawings. In assigning reference numerals to components in each drawing, identical components may be assigned the same reference numerals even when shown in different drawings. If details of known art or functions are deemed to obscure the subject matter of the disclosure, then such details may be omitted. As used herein, terms such as "includes," "has," or "is composed of" in relation to a component permits the inclusion of additional components unless terms like "only" are explicitly used. Additionally, unless the context clearly indicates otherwise, expressions in the singular, such as "a," "an," and "the" are intended to include their plural forms.

Such denotations as "first," "second," "A," "B," "(a)," and "(b)" may be used to describe components of the disclosure. These denotations are intended merely to distinguish one component from another, and are not intended to limit the nature, order, sequence, or number of the components.

Regarding the description of positional relationships between components, when two or more components are described as being "connected," "coupled," or "linked," it should be understood that they may be directly "connected," "coupled," or "linked," or may have an intervening component. Here, the intervening component may be included in one or more of the two or more components that are "connected," "coupled," or "linked" to each other.

When terms such as "after," "next," "subsequent to" or "before," are used to describe the temporal or sequential relationships between components, operation methods, or fabrication methods, they may also encompass a non-continuous case unless terms like "immediately" or "directly" are explicitly used.

When a component is associated with a value or its corresponding information (e.g., level), such value or information may be interpreted to include tolerances arising due to various factors (e.g., process variations, internal or external impacts, or noise), even without explicit separate descriptions.

Hereinafter, various embodiments of the disclosure are described in detail with reference to the accompanying drawings.

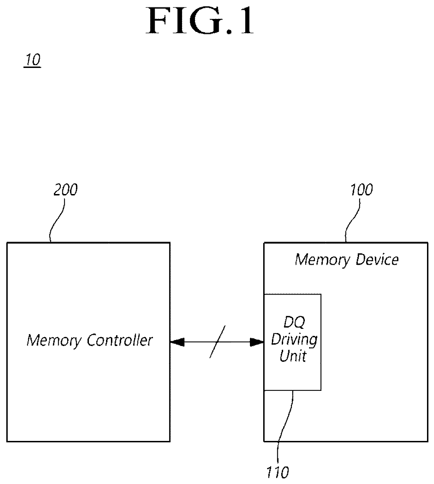

FIG. 1 is a block diagram illustrating a system including a memory device according to embodiments of the present disclosure.

Referring to FIG. 1, a system 10 includes a memory device 100 and a memory controller 200.

The memory device 100 may store data. The memory device 100 may operate in response to the control of the memory controller 200.

The memory device 100 may receive a data signal from the memory controller 200. The memory controller 200 may output a data signal to the memory device 100 or may receive a data signal from the memory device 100 or a host. The data signal includes a command, an address, and data.

The memory device 100 may include a plurality of memory cells. The memory device 100 includes a data driving unit 110 (hereinafter, referred to as "DQ driving unit") and a plurality of data pins (not shown, referred to as "DQ pins"). Data signals from the memory controller 200 are input to the DQ pins of the memory device 100 through a plurality of channels. The DQ driving unit 110 may generate a reference voltage for each DQ pin and may determine a received data signal using PER-PIN reference voltages.

A PER-PIN reference voltage may be set to an appropriate voltage level in consideration of the characteristics of the data signal and the characteristics of the channel through which the data signal is transmitted. Accordingly, the reference voltage may be a different value for each DQ pin.

Information related to the reference voltage for each of the plurality of DQ pins may be stored in the form of code in a separate storage circuit, for example, a mode register. The DQ driving unit 110 may generate a reference voltage based on a reference voltage-related code. The reference voltage-related code may be determined during the training process of the memory device 100.

The memory device 100 may support a termination mode by connecting a termination resistor to the end of the transmission line. The end of the transmission line may be terminated at a constant voltage level by the termination resistor. The memory device 100 may support a first termination mode and a second termination mode. For example, the first termination mode may be a LTT (Low Tap Termination) mode, and the second termination mode may be a PI-LTT (Power Isolated LTT) mode. The reference voltage may have different voltage ranges depending on the termination mode. For example, the range of the reference voltage in the LTT mode and the range of the reference voltage in the PI-LTT may be different from each other.

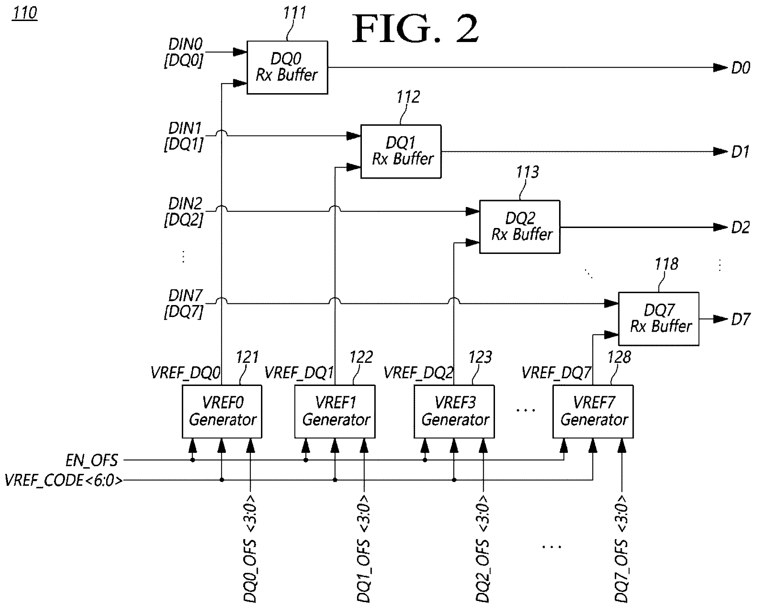

FIG. 2 is a block diagram showing a data driver according to embodiments of the present disclosure.

For the sake of conciseness in descriptions below, a DQ driving unit 110 is described as a receiver that reads input data, but embodiments are not limited thereto. For example, the DQ driving unit 110 may include a transmitter for transmitting data to an external device.

Referring to FIG. 2, the DQ driving unit 110 includes a first reference voltage generator 121 to an eighth reference voltage generator 128 corresponding to a first receiving buffer 111 to an eighth receiving buffer 118, respectively.

The first receiving buffer 111 to the eighth receiving buffer 118 may receive a first input data signal (DIN0) to an eighth input data signal (DIN7) through a first DQ pin (DQ0) to an eighth DQ pin (DQ7), respectively. For example, the first receiving buffer 111 may receive the first input data signal (DIN0) through the first DQ pin (DQ0), and the second receiving buffer 112 may receive the second input data signal (DIN1) through the second DQ pin (DQ1). Similarly, the third receiving buffer 113 to the eighth receiving buffer 118 may receive the third input data signal (DIN2) to the eighth input data signal (DIN7) through the third DQ pin (DQ2) to the eighth DQ pin (DQ7), respectively.

Each of the first reference voltage generator 121 to the eighth reference voltage generator 128 may receive an offset enable signal (EN_OFS), a first code (VREF_CODE<6:0>), and a second code (DQ#_OFS<3:0>, where # is one of the integers between 0 and 7, inclusive.

The offset enable signal (EN_OFS) and the first code (VREF_CODE<6:0>) may be commonly provided to the first reference voltage generator 121 to the eighth reference voltage generator 128. The second code (DQ#_OFS<3:0>) may be individually provided to the first reference voltage generator 121 to the eighth reference voltage generator 128. For example, DQ0_OFS<3:0> may be provided to the first reference voltage generator 121, and DQ1_OFS<3:0> may be provided to the second reference voltage generator 122. Similarly, DQ2_OFS<3:0> to DQ7_OFS<3:0> may be provided to the third reference voltage generator 123 to the eighth reference voltage generator 128, respectively.

The first reference voltage generator 121 to the eighth reference voltage generator 128 may generate reference voltages (VREF_DQ0 to VREF_DQ7) based on the first code (VREF_CODE<6:0>) and the second codes (DQ0_OFS<3:0> to DQ7_OFS<3:0>).

The first code (VREF_CODE<6:0>) represents level information of the internal reference voltage, and the second code (DQ#_OFS<3:0>) represents offset voltage information for adjusting the reference voltage to be used in a current determination operation.

In the second code (DQ#_OFS<3:0>), the most significant bit, DQ#_OFS<3>, represents a positive or negative sign ("+" or " -"), and the remaining bits except for DQ#_OFS<3> (i.e., DQ#_OFS<2:0>), may represent offset voltage values. That is, the second code (DQ#_OFS<3:0>) may represent a positive offset voltage value or a negative offset voltage value. For example, if the level of the internal reference voltage indicated by the first code (VREF_CODE<6:0>) is Vref, and if the second code (DQ0_OFS<3:0>) input to the first reference voltage generator 121 represents +Voffset, then the first reference voltage (VREF_DQ0) output from the first reference voltage generator 121 may have a voltage level of Vref + Voffset.

The reference voltages (VREF_DQ0 to VREF_DQ7) generated by the first reference voltage generator 121 to the eighth reference voltage generator 128 may be different from each other. Alternatively, the reference voltage generated by one of the first reference voltage generator 121 to the eighth reference voltage generator 128 may be different from the reference voltage generated by any other reference voltage generator.

The first receiving buffer 111 to the eighth receiving buffer 118 may receive a reference voltage from a corresponding reference voltage generator, respectively, and may determine a logic level of a data signal input through a corresponding DQ pin based on the received reference voltage. For example, the first receiving buffer 111 may receive a first reference voltage (VREF_DQ0) from the first reference voltage generator 121, determine a logic level of a first input data signal (DIN0) based on the first reference voltage (VREF_DQ0), and generate a first data signal (D0). The second receiving buffer 112 may receive a second reference voltage (VREF_DQ1) from the second reference voltage generator 122, determine a logic level of a second input data signal (DIN1) based on the second reference voltage (VREF_DQ1), and generate a second data signal (D1). The description of the first receiving buffer 111 and the second receiving buffer 112 also applies similarly to the third receiving buffer 113 to the eighth receiving buffer 118.

In FIG. 2, the memory device includes eight receiving buffers and eight reference voltage generators, but other embodiments are not limited thereto. The number of receiving buffers and voltage generators included in the memory device may vary depending on the number of DQ pins.

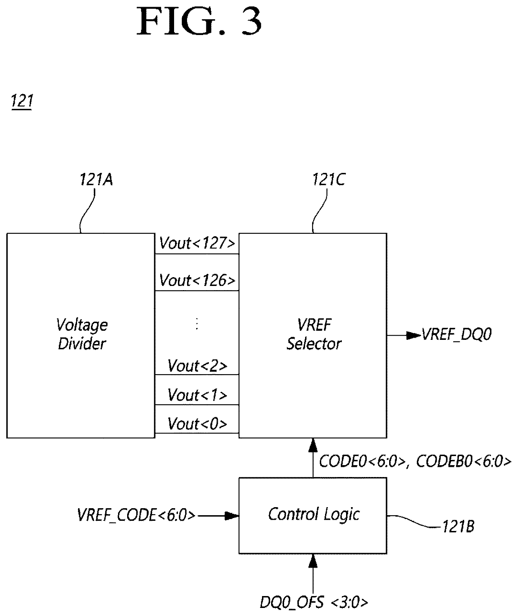

FIG. 3 is a block diagram illustrating a first reference voltage generator of Fig. 2.

The description of a first reference voltage generator 121 described below applies similarly to the second to eighth reference voltage generators (122 to 128) of FIG. 2.

Referring to FIG. 3, the first reference voltage generator 121 includes a voltage divider 121A, a control logic 121B, and a reference voltage selector 121C.

The voltage divider 121A may divide the power supply voltage to generate a plurality of divided voltages (Vout<127:0>).

The reference voltage selector 121C may receive a plurality of divided voltages (Vout<127:0>) from the voltage divider 121A; receive a control code (CODE0<6:0>) and an inverted control code (CODEB0<6:0>) from the control logic 121B; select one of the plurality of divided voltages (Vout< 127:0>) based on the control code (CODE0<6:0>) and the inverted control code (CODEB0<6:0>); and output it as a first reference voltage (VREF_DQ0).

The control logic 121B is enabled by an offset enable signal (EN_OFS of FIG. 2) to generate the control code (CODE0<6:0>) and the inverted control code (CODEB0<6:0>) based on a first code (VREF_CODE<6:0>) and a second code (DQ0_OFS<3:0>).

FIG. 3 illustrates 128 divided voltages (Vout<127:0>) and a control code comprised of 7 bits, but the number of bits of the control code may vary depending on the number of divided voltages. For example, when the number of divided voltages is 2ⁿ (where n is an integer greater than or equal to 2), the control code may be n bits (where n is an integer greater than or equal to 2).

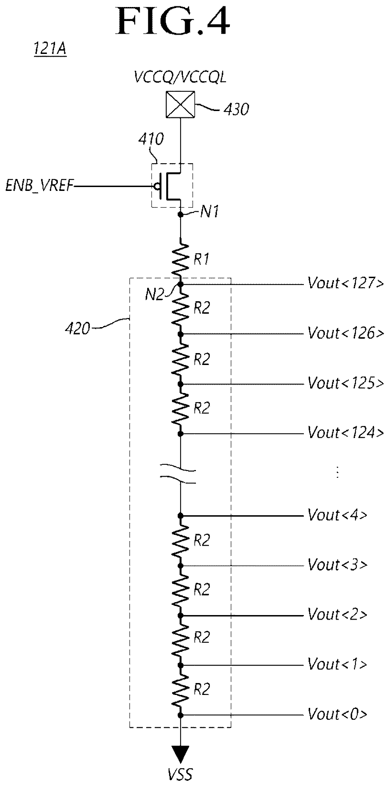

FIG. 4 is an exemplary circuit diagram of a voltage divider of FIG. 3.

Referring to FIG. 4, a voltage divider 121A generates a plurality of divided voltages (Vout<127:0>) in response to an inverted enable signal (ENB_VREF). The voltage divider 121A includes a switch 410, a first resistor (R1), and a resistor ladder 420.

The switch 410 may be connected between a power supply voltage terminal 430 and a first node (N1), and may be turned on in response to an offset enable signal (EN_OFS of FIG. 2). The power supply voltage terminal 430 may be a power supply voltage pin.

The switch 410 may be composed of a PMOS transistor. The drain electrode of the PMOS transistor may be connected to the power supply voltage terminal 430, the source electrode of the PMOS transistor may be connected to the first node (N1), and the inverted enable signal (ENB_VREF) may be input to the gate electrode of the PMOS transistor. The switch 410 may be turned on in response to a low-level inverted enable signal (ENB_VREF) to transmit the power voltage provided to the power supply voltage terminal 430 to the first node (N1).

The level of the power voltage provided to the power supply voltage terminal 430 may vary depending on the termination mode. The power voltage may have a voltage value of a first level in a first termination mode, and a voltage value of a second level, which is different from the first level, in a second termination mode. For example, the first termination mode may be an LTT mode, the second termination mode may be a PI-LTT mode, and the power voltage in the LTT mode may be 1.2 [V], and the power voltage in the PI-LTT mode may be 0.6 [V].

The voltage divider 121A may distribute the power voltage at different levels depending on the termination mode to generate the divided voltages (Vout<127:0>). Accordingly, the reference voltage may have different voltage ranges depending on the termination mode.

The first resistor (R1) is connected between the first node (N1) and a second node (N2). The resistor ladder 420 includes a plurality of second resistors (R2) connected in series between the second node (N2) and the ground node (VSS).

The voltage level of the second node (N2) may be determined by a standard. For example, the voltage level of the second node (N2) may be K times the power supply voltage (where K is a positive number less than 1), and the K value may be determined by the standard. A first resistor (R1) and a second resistor (R2) may have different resistivities. The resistivity of a first resistor (R1) may be greater than the resistivity of a second resistor (R2). Because a first resistor (R1) has a higher resistivity than a second resistor (R2), the area occupied by the first resistor (R1) may be reduced compared to the case in which the first resistor R1 has a resistivity equal to or smaller than that of a second resistor (R2).

The resistor ladder 420 distributes the potential difference between the second node (N2) and the ground voltage terminal (VSS) in a voltage divided manner to generate multiple divided voltages (Vout<127:0>).

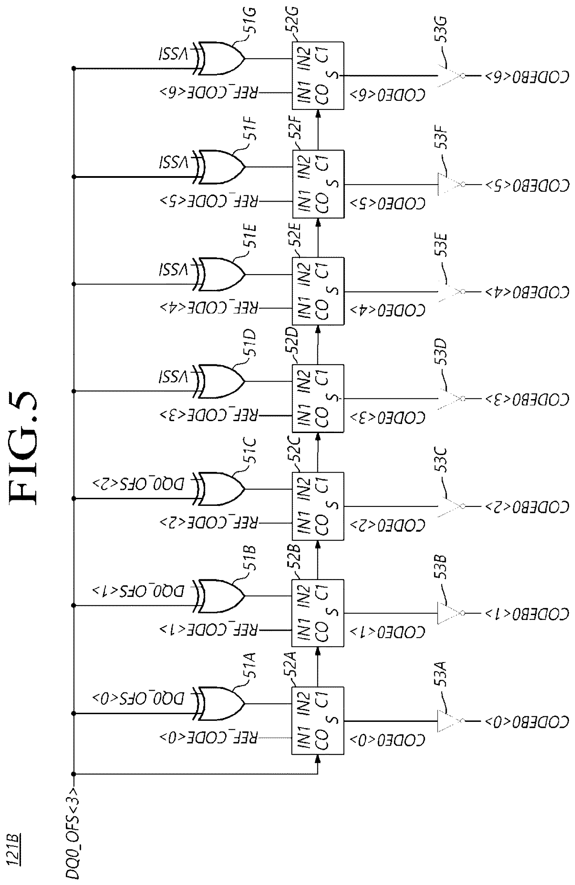

FIG. 5 is an exemplary circuit diagram of a control logic of FIG. 3.

Referring to FIG. 5, a control logic 121B includes a first XOR gate 51A to a seventh XOR gate 51G, a first decrementer 52A to a seventh decrementer 52G, and a first inverter 53A to a seventh inverter 53G.

In each of the first decrementer 52A to the seventh decrementer 52G, IN1 and IN2 are input terminals, CI is a terminal into which a carry value is input, S is an output terminal, and CO is a terminal from which a carry value is output. The operations of each of the first decrementer 52A to the seventh decrementer 52G according to exemplary inputs and outputs are as shown in Table 1 below.

**[Table 1]**

| Example No. | CI | IN1 | IN2 | S | CO |
|---|---|---|---|---|---|
| 1 | 0 | 0 | 0 | 0 | 0 |
| 2 | 0 | 0 | 1 | 1 | 0 |
| 3 | 0 | 1 | 0 | 1 | 0 |
| 4 | 0 | 1 | 1 | 0 | 1 |
| 5 | 1 | 0 | 0 | 1 | 0 |
| 6 | 1 | 0 | 1 | 0 | 1 |
| 7 | 1 | 1 | 0 | 0 | 1 |
| 8 | 1 | 1 | 1 | 1 | 1 |

The most significant bit (DQ0_OFS<3>) of a second code is provided as the setting value of the first decrementer 52A and as first inputs to the first XOR gate 51A to the seventh XOR gate 51G. Remaining bits (DQ0_OFS<2:0>) excluding the most significant bit of the second code are provided as second inputs to the first XOR gate 51A to the third XOR gate 51C, respectively. A low-level voltage (VSSI) is provided as the second input of the fourth XOR gate 51D to the seventh XOR gate 51G.

If the most significant bit (DQ0_OFS<3>) of the second code is '0', then the control logic 121B performs an operation that adds the remaining bits (DQ0_OFS<2:0>) of the second code, excluding the most significant bit, to the first code (REF_CODE<6:0>) to generate a control code (CODE0<6:0>). If the most significant bit (DQ0_OFS<3>) of the second code is '1', then the control logic 121B performs an operation that subtracts the remaining bits (DQ0_OFS<2:0>) of the second code, excluding the most significant bit, from the first code (REF_CODE<6:0>) to generate a control code (CODE0<6:0>).

The input terminals of the first inverter 53A to the seventh inverter 53G are respectively connected to the output terminals (S) of the first decrementers 52A to the seventh decrementer 52G. The control codes ((CODE0<6:0>)) output from the output terminals (S) of the first decrementers 52A to the seventh decrementer 52G are inverted to generate the inverted control code (CODEB0<6:0>).

FIG. 5 shows a case where the number of divided voltages (Vout<127:0>) is 128 and the number of inverters and the number of decrementers are 7, respectively. However, in other embodiments the number of inverters and the number of decrementers may vary depending on the number of divided voltages. For example, when the number of divided voltages is 2ⁿ, the number of inverters and the number of decrementers may be n, respectively.

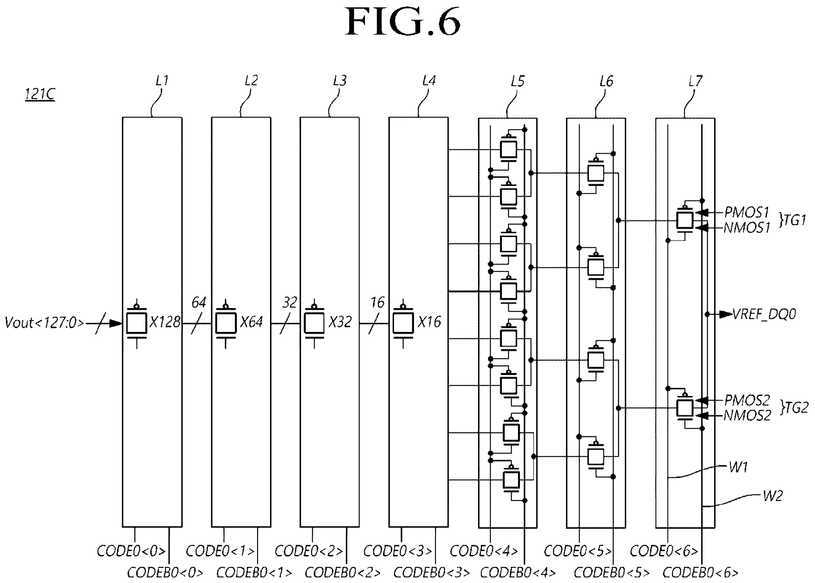

FIG. 6 is a configuration diagram of a reference voltage selector of FIG. 3.

Referring to FIG. 6, a reference voltage selector 121C includes a plurality of transfer gates. The transfer gates may be layered into a plurality of layers (L1 to L7). In an embodiment, the plurality of layers include first to seventh layers (L1 to L7).

The divided voltages (Vout<127:0>) are input from the voltage divider 121A to the input terminals of the transfer gates of the first layer (L1), respectively. The number of transfer gates of the first layer (L1) may be equal to the number of divided voltages (Vout<127:0>). As illustrated in FIG. 6, when the number of divided voltages (Vout<127:0>) is 128, the number of transfer gates of the first layer (L1) may be 128.

In each of the first layer (L1) to the seventh layers (L7), the transfer gates have a binary tree structure. In each of the first layer (L1) to the seventh layer (L7), two transfer gates are paired and connected to one output terminal in common.

The output terminals of the Kth layer are respectively connected to the input terminals of the transfer gates of the(K+1)th layer. The number of transfer gates included in the (K+1)th layer may be half of the number of transfer gates included in the Kth layer. As illustrated in FIG. 6, the numbers of transfer gates included in the first layer (L1), the second layer (L2), the third layer (L3), the fourth layer (L4), the fifth layer (L5), the sixth layer (L6), and the seventh layer (L7) are 128, 64, 32, 16, 8, 4, and 2, respectively.

A transfer gate may have a CMOS structure. That is, a transfer gate may include an NMOS transistor and a PMOS transistor connected in parallel between the input terminal and the output terminal, and may output a signal of the input terminal to the output terminal when both the NMOS transistor and the PMOS transistor are turned on.

One bit of the control code and its inversion bit are input to each of the first layer (L1) to the seventh layer (L7). According to the one bit of the control code and its inversion bit, one of the two transfer gates that form a pair, from among the transfer gates included in the Kth layer, may be turned on and the other one may be turned off. For example, when two transfer gates (TG1, TG2) paired in the seventh layer (L7) are referred to as a first transfer gate (TG1) and a second transfer gate (TG2), one of the first transfer gate (TG1) and the second transfer gate (TG2) may be turned on, and the other may be turned off.

The gate electrode of an NMOS transistor (NMOS1) of the first transfer gate (TG1) and the gate electrode of a PMOS transistor (PMOS2) of the second transfer gate (TG2) may be commonly connected to a first line (W1), and the gate electrode of a PMOS transistor (PMOS1) of the first transfer gate (TG1) and the gate electrode of an NMOS transistor (NMOS2) of the second transfer gate (TG2) may be commonly connected to a second line (W2). CODE0<6> and CODE0<6> are input to the first line (W1) and the second line (W2), respectively. Accordingly, one of the first transfer gate (TG1) and the second transfer gate (TG2) may be turned on and the other may be turned off, so that one of the divided voltage input to the first transfer gate (TG1) and the divided voltage input to the second transfer gate (TG2) can be output. For example, when a "logic high level" is input to the first line (W1) and a "logic low level" is input to the second line (W2), the first transfer gate (TG1) is turned on and the second transfer gate (TG2) is turned off, so that the divided voltage input to the first transfer gate (TG1) is output. Conversely, when a "logic low level" is input to the first line (W1) and a "logic high level" is input to the second line (W2), the first transfer gate (TG1) is turned off and the second transfer gate (TG2) is turned on, so that the divided voltage input to the second transfer gate (TG2) is output.

The transfer gates included in the first layer (L1) to the sixth layer (L6) may also operate similarly to the transfer gates included in the seventh layer (L7).

In FIG. 6, the number of divided voltages is 128, the reference voltage selector (121C) includes seven layers and the control code has seven bits. However, in other embodiments the number of layers included in the reference voltage selector (121C) may vary depending on the number of divided voltages. For example, when the number of divided voltages is 2ⁿ, the number of layers included in the reference voltage selector (121C) may be n, and the control code may be n bits.

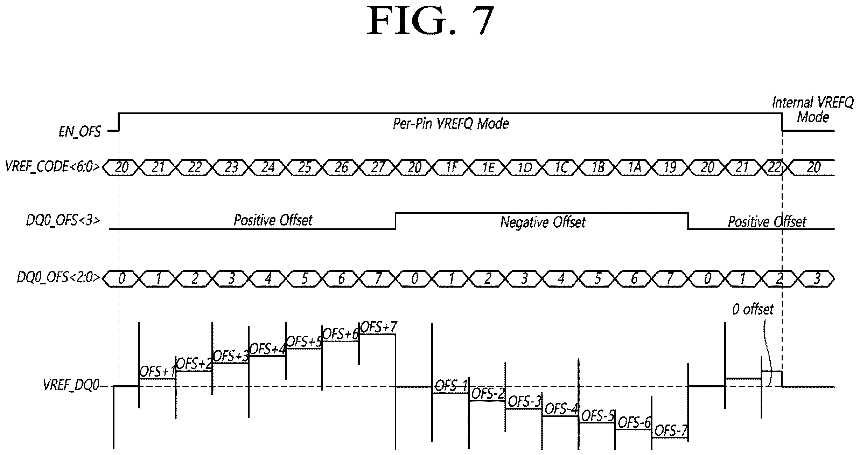

FIG. 7 is a graph illustrating a change in the reference voltage level of the DQ0 pin according to a change in an offset enable signal, first code, and second code in the memory device according to an embodiment of the present disclosure.

Referring to FIG. 7, a DQ driver generates a reference voltage for each DQ pin when an offset enable signal (EN_OFS) is at a "high" level.

When the offset enable signal (EN_OFS) is at a "high" level and when the most significant bit (DQ0_OFS<3>) of a second code (DQ0_OFS<3:0>) is at a "high" level, a first reference voltage generator of the DQ driver generates a reference voltage (VREF_DQ0) of a DQ0 pin by adding an internal reference voltage (0 offset) corresponding to a first code (VREF_CODE<6:0>) and an offset voltage corresponding to DQ0_OFS<2:0>. For example, when the offset enable signal (EN_OFS) is at a "high" level, DQ0_OFS<3> is at a "high" level, and when DQ0_OFS<2:0> is at "4", the first reference voltage generator generates the reference voltage (VREF_DQ0) of the DQ0 pin by adding the internal reference voltage (0 offset) and the offset voltage corresponding to a level "4".

When the offset enable signal (EN_OFS) is at a "high" level and when the most significant bit (DQ0_OFS<3>) of the second code (DQ0_OFS<3:0>) is at a "low" level, the first reference voltage generator subtracts the offset voltage corresponding to DQ0_OFS<2:0> from the internal reference voltage (0 offset) to generate the reference voltage (VREF_DQ0) of the DQ0 pin. For example, when the offset enable signal (EN_OFS) is at a "low" level, when DQ0_OFS<3> is at a "low" level, and when DQ0_OFS<2:0> is "4", the first reference voltage generator subtracts the offset voltage corresponding to "4" levels from the internal reference voltage (0 offset) to generate the reference voltage (VREF_DQ0) of the DQ0 pin. In FIG. 7, when the offset enable signal (EN_OFS) transitions from the "low" level to the "high" level, DQ0_OFS<2:0> is "0". Accordingly, the offset voltage is 0, and the reference voltage (VREF_DQ0) of the DQ0 pin has the same value as the internal reference voltage (0 offset).

When the offset enable signal (EN_OFS) is at the "low" level, the DQ driver sets the reference voltages of all DQ pins to the internal reference voltage (0 offset). In FIG. 7, when the offset enable signal (EN_OFS) transitions from the "high" level to the "low" level, the DQ0 reference voltage (VREF_DQ0) transitions from the OFS+2 value to the internal reference voltage (0 offset). During the period where the offset enable signal (EN_OFS) is at the "low" level, the DQ0 reference voltage (VREF_DQ0) is maintained as the internal reference voltage (0 offset).

The advantages according to embodiments of the present disclosure include the following.

Unlike the present disclosure, there may be a method of configuring 2ⁿ transfer gates that each input 2ⁿ divided voltages, turning on one of the 2ⁿ transfer gates and turning off the rest to select one of the 2ⁿ divided voltages as a reference voltage. In this case, because a 2ⁿ-bit control code is required to control the 2ⁿ transfer gates, a large number of elements are required to configure a circuit that generates the control code, and the circuit that generates the control code may have a large size. Because the reference voltage selector (121C) according to the present disclosure uses only an n-bit control code to select one of the 2ⁿ divided voltages, the control logic that generates the control code can be configured in a smaller size using a small number of elements. As a result, the area efficiency can be improved.

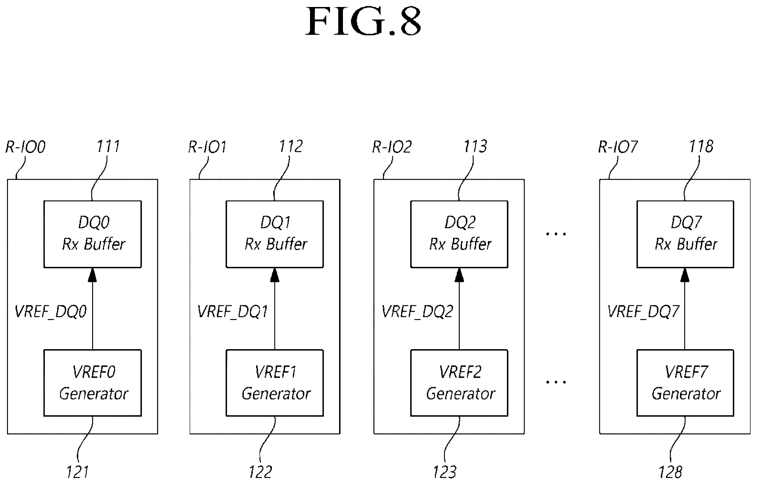

FIG. 8 is a schematic diagram illustrating an arrangement of receiving buffers and reference voltage generators according to embodiments of the present disclosure.

Referring to FIG. 8, a memory device includes a first input/output circuit region (R-IO0) to an eighth input/output circuit region (R-IO7) corresponding to first to eighth DQ pins, respectively. Although not illustrated, first to eighth DQ pins may be arranged in the first input/output circuit region (R-IO0) to the eighth input/output circuit region (R-IO7), respectively. FIG. 8 includes eight input/output circuit regions, but this is merely an example and in other embodiments the number of input/output circuit regions may vary depending on the number of DQ pins.

The first input/output circuit region (R-IO0) to eighth input/output circuit region (R-IO7) may be arranged in a row along a first horizontal direction (HD1).

Each of the first input/output circuit region (R-IO0) to eighth input/output circuit region (R-IO7) includes one receiving buffer and one reference voltage generator. In each of the first input/output circuit region (R-IO0) to eighth input/output circuit region (RIO7), a reference voltage output from a reference voltage generator is input to a receiving buffer. For example, a first receiving buffer 111 and a first reference voltage generator 121 are arranged in the first input/output circuit region (R-IO0). A first reference voltage (VREF_DQ0) output from the first reference voltage generator 121 is input to the first receiving buffer 111. The description of the first input/output circuit region (R-IO0) is similarly applied to the second input/output circuit region (R-IO1) to the eighth input/output circuit region (R-IO7).

Unlike the present disclosure, in comparative devices the reference voltage generator may be arranged in a separate region from the receiving buffer. In this case, the wiring for transmitting the reference voltage output from the reference voltage generator to the receiving buffer becomes longer, and the time delay that occurs in the process of transmitting the reference voltage increases, so that the settling time of the reference voltage might exceed the preset threshold value and signal characteristics may deteriorate.

According to the present disclosure, because the reference voltage generator and the receiving buffer into which the reference voltage output from the reference voltage generator is input are arranged in a single input/output circuit area, the wiring for transmitting the reference voltage can be configured to have a shorter length. Further, the time delay that occurs in the process of transmitting the reference voltage output from the reference voltage generator to the receiving buffer can be reduced and the settling time of the reference voltage can be shortened.

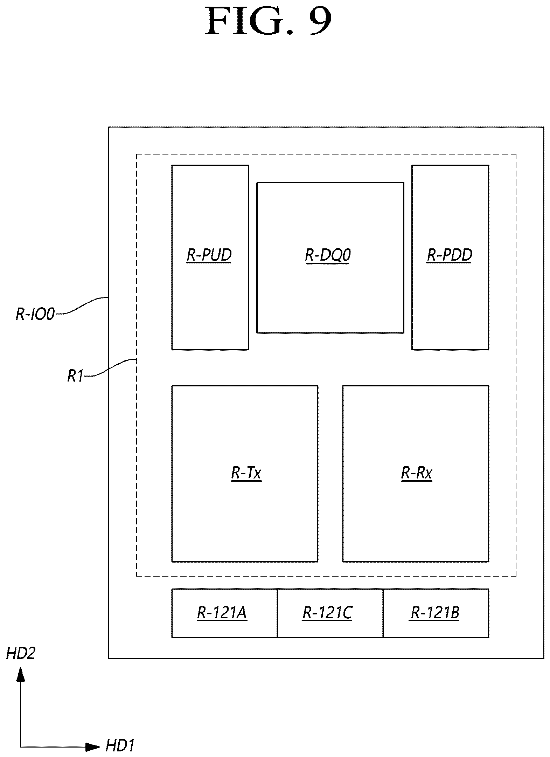

FIG. 9 to FIG. 11 are schematic drawings illustrating a layout structure of a first input/output circuit region of FIG. 8.

Referring to FIG. 9, a first input/output circuit region (R-IO0) includes a first region (R1) and a reference voltage generator region (R-121A, R-121B, and R-121C).

The first region (R1) includes a DQ pin region (R-DQ0), a transmission buffer region (R-Tx), and a receiving buffer region (R-Rx). A DQ pin may be arranged in the DQ pin region (R-DQ0), a transmission buffer may be arranged in the transmission buffer region (R-Tx), and a receiving buffer may be arranged in the receiving buffer region (R-Rx).

In an embodiment, the reference voltage generator regions (R-121A, R-121B, and R-121C) may be arranged outside the first region (R1). The reference voltage generator regions (R-121A, R-121B, and R-121C) may be arranged adjacent to the receiving buffer region (R-Rx) and the transmission buffer region (R-Tx) in the second horizontal direction (HD2).

The reference voltage generator regions include a voltage divider region (R-121A), a control logic region (R-121B), and a reference voltage selector region (R-121C). A voltage divider (121A), a control logic (121B), and a reference voltage selector (121C) of FIG. 3 are respectively arranged in the voltage divider region (R-121A), the control logic region (R-121B), and the reference voltage selector region (R-121C).

The receiving buffer region (R-Rx) is arranged closer to the reference voltage selector region (R-121C) than the DQ pin region (R-DQ0). At least a part of the reference voltage selector region (R-121C) may overlap with the receiving buffer region (R-Rx) in the second horizontal direction (HD2). The voltage divider region (R-121A) and the control logic region (R-121B) may be respectively arranged on both sides of the reference voltage selector region (R-121C) in the first horizontal direction (HD1).

In the first region (R1), a pull-up driver region (R-PUD) and a pull-down driver region (R-PDD) may be respectively arranged on both sides of the first horizontal direction (HD1) of the DQ pin region (R-DQ0). A pull-up driver is arranged in the pull-up driver region (R-PUD), and a pull-down driver is arranged in the pull-down driver region (R-PDD).

According to the present disclosure, the reference voltage selector region (R-121C) is adjacent to the receiving buffer region (R-Rx) and at least a part of the reference voltage selector region (R-121C) overlaps with the receiving buffer region (R-Rx) in the second horizontal direction (HD2). Accordingly, the wiring for transmitting the reference voltage output from the reference voltage selector to the receiving buffer may be configured to have a shorter length when connecting the reference voltage selector region (R-121C) and the receiving buffer region (R-Rx), and may extend in the second horizontal direction (HD2).

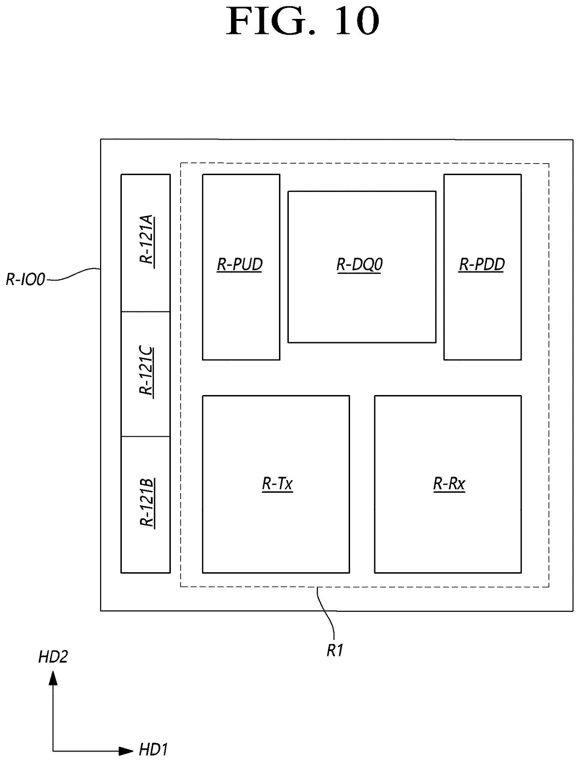

Referring to FIG. 10, reference voltage generator regions (R-121A, R-121B, and R-121C) may be arranged adjacent to the first region (R1) in the first horizontal direction (HD1). As illustrated in FIG. 10, the reference voltage generator regions (R-121A, R-121B, and R-121C) may be arranged on the left side of the first region (R1). Although not illustrated, the reference voltage generator regions (R-121A, R-121B, and R-121C) may also be arranged on the right side of the first region (R1).

At least a part of the reference voltage selector region (R-121C) may overlap with the receiving buffer region (R-Rx) in the first horizontal direction (HD1). The voltage divider region (R-121A) and the control logic region (R-121B) are respectively arranged on both sides of the reference voltage selector region (R-121C) in the second horizontal direction (HD2).

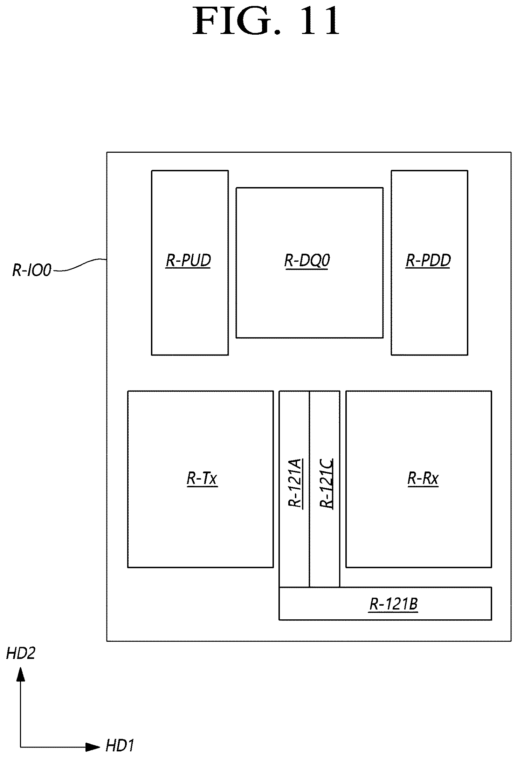

Referring to FIG. 11, the voltage divider region (R-121A) and the reference voltage selector region (R-121C) may be arranged between the transmission buffer region (R-Tx) and the receiving buffer region (R-Rx).

The reference voltage selector region (R-121C) may be arranged closer to the receiving buffer region (R-Rx) than the voltage divider region (R-121A). The reference voltage selector region (R-121C) may be arranged between the voltage divider region (R-121A) and the receiving buffer region (R-Rx) in the first horizontal direction (HD1). The voltage divider region (R-121A) may be arranged between the reference voltage selector region (R-121C) and the transmission buffer region (R-Tx) in the first horizontal direction (HD1).

The control logic region (R-121B) may overlap with the reference voltage selector region (R-121C) in the second horizontal direction (HD2). For example, the control logic region (R-121B) may be arranged adjacent to the voltage divider region (R-121A), the reference voltage selector region (R-121C), and the receiving buffer region (R-Rx) in the second horizontal direction (HD2).

The above description merely provides an illustrative explanation of the present disclosure. Accordingly, a person of ordinary skill in the art to which the present disclosure pertains can make various modifications and variations without departing from the essential characteristics of the present disclosure. In addition, the embodiments disclosed in the present disclosure are not intended to limit the scope of the present disclosure but rather to explain it. Therefore the scope of the present disclosure should not be limited by the embodiments.

## Claims

1. A memory device comprising:
a plurality of reference voltage generators, each of which corresponds to a plurality of data pins and generates a reference voltage for each of the corresponding data pins,
wherein each of the plurality of reference voltage generators comprises:
a voltage divider that divides a power supply voltage into a plurality of divided voltages;
a control logic that receives a first code indicating an internal reference voltage level information and a second code indicating an offset voltage information for a corresponding data pin, and generates a control code based on the first and second codes; and
a reference voltage selector comprising a plurality of tree-structured transfer gates that selects one of the plurality of divided voltages in response to the control code and outputs the selected divided voltage as the reference voltage.

2. The memory device according to claim 1,
wherein the plurality of tree-structured transfer gates are grouped into a plurality of layers,
wherein in each of the plurality of layers, two transfer gates share one output terminal, and
wherein in response to the control code, one of the two transfer gates is turned on and the other one is turned off.

3. The memory device according to claim 1, wherein the number of the plurality of divided voltages is 2ⁿ, and the control code is n bits, wherein n is an integer greater than or equal to 2.

4. The memory device according to claim 1,
wherein a voltage of a first level is provided to the voltage divider as the power supply voltage in a first termination mode, and
wherein a voltage of a second level different from the first level is provided to the voltage divider as the power supply voltage in a second termination mode.

5. The memory device according to claim 1,
wherein the voltage divider comprises:
a switch connected between a power supply voltage terminal and a first node, and turned on in response to an inverted enable signal;
a first resistor connected between the first node and a second node; and
a resistor ladder comprising a plurality of second resistors connected in series between the second node and a ground voltage terminal, and
wherein the first resistor has a different resistivity from a second resistor.

6. The memory device according to claim 5, wherein the first resistor has a higher resistivity than a second resistor.

7. The memory device according to claim 1, wherein the control logic comprises a plurality of decrementers that add or subtract remaining bits of the second code, excluding a most significant bit of the second code, from the first code.

8. The memory device according to claim 1,
wherein the first code is provided in common to the plurality of reference voltage generators, and
wherein the second code provided to a first reference voltage generator among the plurality of reference voltage generators and the second code provided to a second reference voltage generator among the plurality of reference voltage generators are different from each other.

9. A memory device comprising:
a plurality of input/output circuit regions, each of which corresponds to a plurality of data pins,
wherein each of the plurality of input/output circuit regions comprises:
a receiving buffer region; and
a reference voltage generator region that provides a reference voltage to the receiving buffer region,
wherein the reference voltage generator region comprises:
a voltage divider region that divides a power supply voltage into a plurality of divided voltages;
a control logic region that receives a first code indicating internal reference voltage level information and a second code indicating offset voltage information for a corresponding data pin and that generates a control code based on the first and second codes; and
a reference voltage selector region that selects one of the plurality of divided voltages in response to the control code and outputs the selected divided voltage as the reference voltage.

10. The memory device according to claim 9,
wherein each of the plurality of input/output circuit regions further comprises a data pin region and a transmission buffer region,
wherein the data pin region, the receiving buffer region, and the transmission buffer region are included in a first region, and
wherein the reference voltage generator region is arranged outside the first region.

11. The memory device according to claim 10,
wherein the plurality of input/output circuit regions are arranged in a row along a first horizontal direction,
wherein the reference voltage generator region is arranged adjacent to the first region in a second horizontal direction, and
wherein the second horizontal direction is perpendicular to the first horizontal direction.

12. The memory device according to claim 11, wherein the receiving buffer region is arranged closer to the reference voltage generator region than to the data pin region.

13. The memory device according to claim 11, wherein at least part of the reference voltage selector region overlaps with the receiving buffer region in the second horizontal direction.

14. The memory device according to claim 11, wherein the voltage divider region and the control logic region are respectively arranged on both sides of the reference voltage selector region in the first horizontal direction.

15. The memory device according to claim 10,
wherein the plurality of input/output circuit regions are arranged in a row along a first horizontal direction, and
wherein the reference voltage generator region is arranged adjacent to the first region in the first horizontal direction.

16. The memory device according to claim 15, wherein at least part of the reference voltage selector region overlaps with the receiving buffer region in the first horizontal direction.

17. The memory device according to claim 15, wherein the voltage divider region and the control logic region are respectively arranged on both sides of the reference voltage selector region in a second horizontal direction perpendicular to the first horizontal direction.

18. The memory device according to claim 10,
wherein the plurality of input/output circuit regions are arranged in a row along a first horizontal direction, and
wherein the voltage divider region and the receiving buffer region are respectively arranged on both sides of the reference voltage selector region in the first horizontal direction.

19. The memory device according to claim 18,
wherein the receiving buffer region and the transmission buffer region are arranged along the first horizontal direction, and
wherein the voltage divider region and the reference voltage selector region are respectively arranged between the receiving buffer region and the transmission buffer region.
